(19) **Europäisches Patentamt**

**European Patent Office**

**Office européen des brevets**

(11) **EP 0 949 735 B1**

(12) **EUROPÄISCHE PATENTSCHRIFT**

(45) Veröffentlichungstag und Bekanntmachung des Hinweises auf die Patenterteilung:
**17.07.2002 Patentblatt 2002/29**

(51) Int Cl.7: **H02H 3/20**, G01R 31/327, H02H 7/00

(21) Anmeldenummer: **99106799.2**

(22) Anmeldetag: **06.04.1999**

(54) **Verfahren und Schaltungsanordnung zur Sicherheitsüberprüfung einer Hochspannungsversorgungsanlage**

Method and circuit arrangement for safety control of a high voltage supply system

Procédé et circuit pour la surveillance de la sécurité d'un système d'alimentation à haute tension

(84) Benannte Vertragsstaaten:
**AT BE DE ES FI FR GB IT NL PT SE**

(30) Priorität: **09.04.1998 DE 19816140**

(43) Veröffentlichungstag der Anmeldung:
**13.10.1999 Patentblatt 1999/41**

(73) Patentinhaber: **Schnier Elektrostatik GmbH**
**72810 Gomaringen (DE)**

(72) Erfinder:
• **Luderer, Fred**
**71566 Althütte (DE)**
• **Schnier, Olav**
**72585 Riederrich (DE)**
• **Raissle, Thomas**
**72555 Metzingen (DE)**

(74) Vertreter: **König, Beate, Dipl.-Phys. Dr.**
**König & Köster,**
**Morassistrasse 8**
**80469 München (DE)**

(56) Entgegenhaltungen:
**EP-A- 0 561 146**   **EP-A- 0 722 092**
**GB-A- 2 116 386**   **US-A- 4 912 588**

**Beschreibung**

Die Erfindung betrifft ein Verfahren und eine Schaltungsanordnung gemäß dem Oberbegriff der unabhängigen Patentansprüche.

In elektrostatischen Sprühanlagen beispielsweise zur serienweisen Beflockung oder Lackierung von Werkstücken werden die Sprühorgane bekanntlich an eine Hochspannungsversorgungsanlage angeschlossen, die im wesentlichen aus einem in der Regel innerhalb einer Sprühkabine befindlichen Hochspannungserzeuger und einer außerhalb der Kabine angeordneten Steuerelektronik besteht. Die Steuerelektronik hat neben der Einregelung der erforderlichen Betriebsspannung und/oder eventuell des Stroms auf vorbestimmte Sollwerte u.a. auch die Aufgabe, bei gefährlicher, zu Spannungsüberschlägen führender Annäherung der z.B. auf einer Spannung in der Größenordnung von 100 kV liegenden Sprühvorrichtung an das geerdete Werkstück die Hochspannung abzuschalten. Bei konstanter Betriebsspannung wird die gefährliche Annäherung durch den mit kleiner werdendem Abstand exponentiell ansteigenden Strom festgestellt. Die Hochspannung wird abgeschaltet, sobald der Strom einen vorbestimmten Grenzwert übersteigt.

Aus Sicherheitsgründen muß die Funktionsfähigkeit dieser Abschaltautomatik regelmäßig überprüft werden. Beispielsweise verlangt die europäische Norm EN 50176 für ortsfeste elektrostatische Sprühanlagen für brennbare flüssige Beschichtungsstoffe, daß die ordnungsgemäße Funktion des Schutzes gegen Überströme, also die vorgeschriebene Einrichtung zur selbsttätigen Abschaltung der Hochspannung bei nicht zulässigem Anstieg des Betriebsstroms, täglich überprüft werden muß.

Die Sicherheitsüberprüfung war bisher nur in relativ langen Betriebspausen möglich und erfolgte dadurch, daß in einem Test bei eingeschaltetem Hochspannungserzeuger der Abstand zwischen einem geerdeten Teil und der Sprühvorrichtung selbst oder einem an deren Stelle an den Hochspannungserzeuger angeschlossenen Testelement manuell bis zum Abschalten verringert und hierbei anhand einer angeschlossenen Meßeinrichtung festgestellt wurde, bei welchem Stromwert die Abschaltautomatik ansprach. War dieser tatsächliche Schwellwert zu hoch (oder zu niedrig), wurden durch manuelles Verstellen der Sollwerte der übergeordneten Steuerelektronik und weitere Testvorgänge die Betriebsparameter so lange nachjustiert, bis die Abschaltung bei dem richtigen Schwellwert erfolgte. Da diese Testvorgänge für jeden der gewöhnlich individuell für jedes Sprühorgan vorgesehenen Hochspannungserzeuger (z.B. für die neun Kaskaden der neun Zerstäuber einer typischen Kraftfahrzeug-Beschichtungsanlage) durchgeführt werden müssen, und zwar von normalerweise mindestens zwei Personen, von denen die eine in der Kabine arbeitete und die andere die entfernte Steuerelektronik justieren mußte, waren sie sehr arbeits- und zeitaufwendig. Vor allem die durch den Zeitaufwand bedingten notwendigen langen Betriebspausen sind bei der Serienbeschichtung von Werkstücken aus wirtschaftlichen Gründen unerwünscht. Wegen des großen Aufwands besteht auch die Gefahr, daß die Sicherheitsüberprüfung nicht immer mit der nötigen Sorgfalt durchgeführt wird.

Darüber hinaus sind die bisher üblichen Testvorgänge relativ ungenau und unzuverlässig. Zum einen ist nicht gewährleistet, daß die mit den eigenen Meßinstrumenten der Testvorrichtung gemessenen Werte genau mit den sich im Beschichtungsbetrieb tatsächlich ergebenden Werten übereinstimmen. Ferner ist es wegen des im engen Annäherungsbereich extrem steilen Stromanstiegs schwierig oder unmöglich, mit den Meßinstrumenten der bekannten Testvorrichtung den genauen Stromwert festzustellen, bei dem die Hochspannung abgeschaltet wird.

Patentschrift US4912588 (Thomé et al.) offenbart ein Verfahren zur Überwachung einer Hochspannungsversorgungsanlage in einer elektrostatischen Sprühanlage.

Der Erfindung liegt die Aufgabe zugrunde, die geschilderten Nachteile zu vermeiden und ein Verfahren und eine entsprechende Schaltungsanordnung anzugeben, die eine schnellere, zuverlässigere, einfachere und entsprechend wirtschaftlichere Überprüfung einer Hochspannungsversorgungsanlage ermöglichen.

Diese Aufgabe wird durch die Merkmale der unabhängigen Patentansprüche gelöst.

Während also bisher die Tests auch bei Simulation der Annäherung mit einer gesonderten Testanordnung anstelle der Sprühorgane nur unter Verwendung der Hochspannungserzeuger durchgeführt wurden, können erfindungsgemäß die Testsignale der Hochspannungssteuerschaltung unmittelbar, d.h. auch ohne deren Verbindung mit dem Hochspannungserzeuger zugeführt werden. Die Erfindung hat den Vorteil, daß die Prüfung der Abschaltautomatik vollautomatisch oder von einer einzigen Person außerhalb der Sprühkabine in kürzester Zeit durchgeführt werden kann, beispielsweise in wenigen Sekunden pro Sprühorgan.

Wichtig ist ferner, daß bei der Erfindung problemlos ein genau definierter Strom-Ist-Wert simuliert werden kann.

Die Erfindung läßt sich mit einfachen Mitteln auch als Schaltmodul zur Nachrüstung bereits vorhandener Sprühanlagen einsetzen.

In Weiterbildung der Erfindung kann zusätzlich die Restenergie ermittelt werden, die zu einem vorbestimmten Zeitpunkt nach Abschalten der Hochspannung noch in dem von dem Hochspannungserzeuger gespeisten Energiespeichersystem verblieben ist, und bei Überschreiten eines zulässigen Wertes ein Alarm- oder Schaltsignal erzeugt werden. Die Sprühkabine, in der sich das Energiespeichersystem befindet, ist nämlich während des Beflockungs- oder Beschichtungsbetriebes unzugänglich und kann üblicherweise nur nach Abschalten der Hochspannung betreten werden. Hierbei besteht das Problem, daß beim Abschalten in dem von dem Hochspannungserzeuger zuvor gespeisten System zunächst noch eine erhebliche Ladungsenergie $E=\frac{1}{2}CU^2$ gespeichert ist, wobei C die Gesamtkapazität des Energiespeichersystems und U die Hochspannung bedeuten. Dieses Energiespeichersystem besteht aus dem oder den an den Hochspannungserzeuger angeschlossenen Sprühorganen bzw. deren Elektroden, ggf. dem über das Sprühorgan aufgeladenen Materialversorgungssystem und den sonstigen mit dem Sprühorgan leitend verbundenen spannungsführenden Teilen der Anlage. Aus Sicherheitsgründen muß dafür gesorgt werden, daß bei Freigabe des Zugangs in die Sprühkabine nach einer vorbestimmten Zeit nach Abschalten der Hochspannung, beispielsweise nach 2 Sekunden, die gespeicherte Restenergie auf eine für den Menschen bei Berührung irgendeines leitenden Teils des Systems und/oder hinsichtlich eventueller Kurzschlüsse gegen Erde ungefährlichen Wert abgesunken ist. Diese Restenergie soll nach derzeit geltenden Bestimmungen für bestimmte Anlagen maximal 350 mWs betragen. Aufgrund anderer Kriterien darf bei Berührung kein höherer Strom als 0,7 mA möglich sein.

Bei Beflockungs- oder Beschichtungsanlagen der hier betrachteten Art hat man versucht, das Energiespeichersystem mit normalerweise offenen, nach dem Abschalten der Hochspannung geschlossenen Erdschaltern plötzlich zu entladen. Diese Methode hat sich nicht überall bewährt, hauptsächlich wegen der über die Erdschalter fließenden erheblichen Ströme, die kurzzeitig in der Größenordnung von 10 kA liegen können, und der hohen Spannungen, die an den notwendigen Dämpfungswiderständen abfallen und elektronische und sonstige Anlagenteile gefährden können. Üblich sind stattdessen ständig zwischen das Energiespeichersystem und Erde geschaltete Entladewiderstände, die so bemessen sind, daß innerhalb der vorgeschriebenen Zeit von beispielsweise zwei Sekunden nach Abschalten der Hochspannung die Restenergie auf den zulässigen Wert von 350 mWs absinkt. In der Praxis hat sich aber gezeigt, daß die vorhandenen Entladekreise nicht absolut zuverlässig und störsicher sind. Es kommt immer wieder vor, daß der Zugang in die Kabine freigegeben wird, obwohl dem Energiespeichersystem noch eine lebensgefährlich hohe Restenergie entnehmbar geblieben ist. Ein Grund hierfür kann beispielsweise sein, daß ein Entladewiderstand defekt ist oder versehentlich oder sogar aus irgendeinem Grund absichtlich abgetrennt wurde, so daß es wesentlich länger als aufgrund der Anlagenkonstruktion vorgesehen dauert, bis die gespeicherte Energie auf den ungefährlichen Restwert abgesunken ist. Ein anderer Grund kann eine zu hohe Betriebsspannung sein, beispielsweise wenn in einer Beflockungsanlage die an sich auf einen vorgegebenen Maximalwert begrenzte Hochspannung versehentlich oder infolge eines Fehlers oder aus irgendwelchen Gründen absichtlich auf einen höheren Wert eingestellt war. Auch in diesem Fall dauert nach dem Abschalten die Entladung über die gemäß der normalen Maximalspannung dimensionierten Entladewiderstände entsprechend länger als eigentlich vorgesehen. Aus diesen Gründen besteht erheblich Unfallgefahr, tatsächliche Unfälle sind in der Praxis nicht selten.

Demgemäß stellt sich die zusätzliche Aufgabe, ein Verfahren und eine entsprechende Schaltungsanordnung anzugeben, die einen gesicherten Zugang in den die Sprühorgane enthaltenden Raum nach dem Abschalten der Hochspannung ohne die geschilderte Unfall- und/oder Kurzschlußgefahr auch dann gewährleisten, wenn die Energieentladekreise der Sprühanlage versagen oder beispielsweise wegen zu hoher vorheriger Betriebsspannung nicht im vorgesehenen Zeitraum wirken. Dies wird durch die Merkmale der Patentansprüche 7 bzw. 11 erreicht. Hierdurch wird mit überraschend geringem Schaltungs- und ggf. Softwareaufwand einer einfachen Überprüfeinheit eine ganz erhebliche Verbesserung der Unfallsicherheit in elektrostatischen Sprühanlagen erreicht. Ein wichtiger zusätzlicher Vorteil besteht darin, daß die Überwachung der Abschaltsicherheit, also die Sicherstellung des Zugangs beispielsweise in eine Sprühkabine ohne Gefährdung durch zu hohe Restladenergie, ständig oder kontinuierlich und ohne jeden Eingriff in den normalen Anlagenbetrieb durchgeführt werden kann.

An dem in der Zeichnung dargestellten Ausführungsbeispiel wird die Erfindung näher erläutert. Es zeigen:

Fig. 1    eine Ausführungsform der Schaltungsanordnung gemäß der Erfindung;

Fig. 2    eine Abwandlung der Schaltung nach Fig. 1, bei der eine Überprüfung der richtigen Entladung des Energiespeichersystems durchführbar ist.

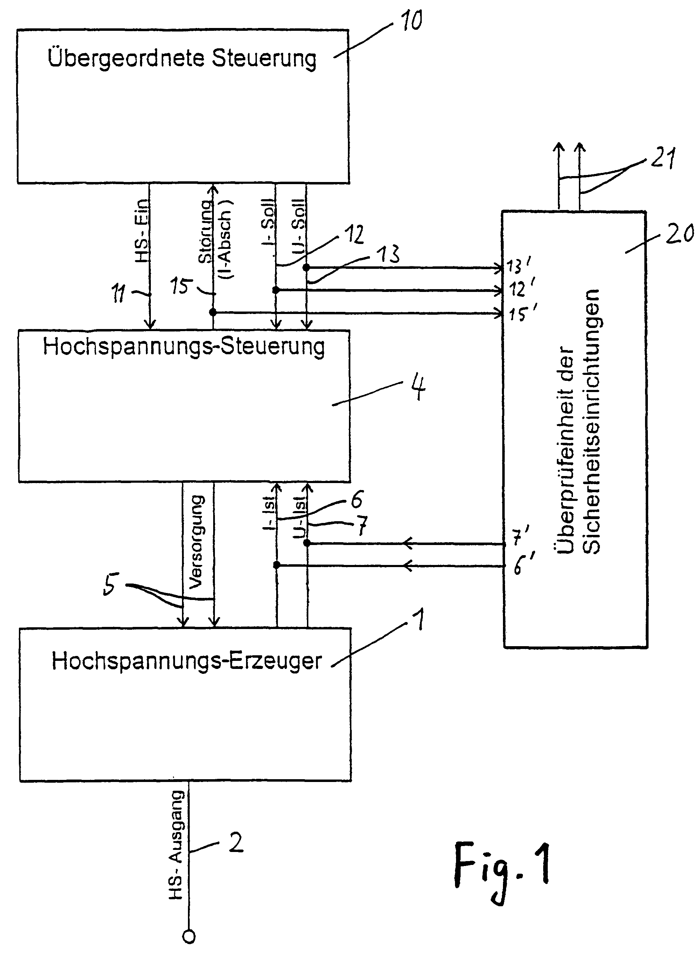

Gemäß Fig. 1 ist ein Hochspannungserzeuger 1, der konventionell aus einer Kaskade mit zugehöriger Elektronik und einem Hochspannungstransformator bestehen kann, an seinem Hochspannungsausgang 2 an ein (nicht dargestelltes) Sprühgerät angeschlossen.

Zum Regeln, Steuern, Überwachen und Abschalten des Hochspannungserzeugers 1 dient eine elektronische Steuerschaltung 4, die Ausgänge 5 für die Spannungsversorgung des Hochspannungserzeugers 1 sowie ebenfalls mit diesem verbundene Eingänge 6 und 7 hat, an denen ihr beim Sprühbetrieb die Ist-Werte des Stroms und der Spannung des Hochspannungserzeugers zugeführt werden. Die Steuerschaltung 4 kann außerhalb einer Sprühkabine angeordnet sein, während sich der Hochspannungserzeuger 1 in der Regel in der Nähe des zugehörigen Sprühorgans innerhalb der Kabine befindet.

Die aus dem Hochspannungserzeuger 1 und der Steuerschaltung 4 bestehende Hochspannungsversorgungsanlage wird von einer mit 10 bezeichneten übergeordneten Steuerung der Sprühanlage gesteuert und hat zu diesem Zweck einen Eingang 11 für ein Hochspannungsschaltsignal sowie Eingänge 12 und 13 für Stromund Spannungssollwerte. Ferner hat die Steuerschaltung 4 einen Ausgang 15, an dem sie der Steuerung 10 im Fall einer Störung, insbesondere bei Überschreiten eines vorgegebenen Betriebsstromschwellwertes, ein Abschaltsignal zuführt.

Zur Sicherheitsüberprüfung der Hochspannungsversorgungsanlage dient eine Test- oder Überprüfeinheit 20, die mit den Eingängen 12 und 13 und dem Ausgang 15 der Steuerschaltung 4 verbundene Eingänge 12', 13' und 15' sowie mit den Eingängen 6, 7 verbundene Ausgänge 6', 7' hat.

Zur Überprüfung der Hochspannungsversorgungsanlage wird die Verbindung zwischen den Eingängen 6 und/oder 7 der Steuerschaltung 4 und dem Hochspannungserzeuger 1 unterbrochen, z.B. durch Schalter oder elektronische Entkopplung zwischen dem Hochspannungserzeuger und den Anschlußstellen der Ausgänge 6', 7' der Überprüfeinheit. Die von der übergeordneten Steuerung 10 kommenden Sollwerte für Spannung und Strom werden von der Überprüfeinheit 20 abgefragt, die nun den Spannungssollwert der Steuerschaltung 4 am Eingang 7 als Ist-Wert zuführt, so daß für die Hochspannungssteuerung die Erzeugung einer ausreichenden Hochspannung durch den Hochspannungserzeuger simuliert wird. Der Hochspannungserzeuger 1 kann bei der Überprüfung abgeschaltet werden.

Ferner wird der beim Sprühbetrieb vom Hochspannungserzeuger 1 kommende Strom-Ist-Wert am Eingang 6 der Steuerschaltung 4 durch ein von der Überprüfeinheit 20 erzeugtes Testsignal ersetzt. Dieses den Strom-Ist-Wert simulierende Signal wird von Null oder einem sehr kleinen Stromwert ausgehend vorzugsweise kontinuierlich bis zu einer Größe hochgefahren, bei der die Steuerschaltung wie auf ein echtes Überstromsignal des Hochspannungserzeugers ansprechend die betreffende Störung meldet und das entsprechende Abschaltsignal am Ausgang 15 erzeugt. Sobald die Überprüfeinheit 20 an ihrem Eingang 15' das Abschaltsignal erhält, speichert sie den zu diesem Zeitpunkt von ihr simulierten Strom-Ist-Wert. Dieser Wert wird mit dem Strom-Soll-Wert am Eingang 12' verglichen. Wenn das Ergebnis des Vergleiches innerhalb eines einstellbaren "Fensters" liegt, meldet die Überprüfeinheit an weiteren Ausgängen 21 einwandfreie Funktion der Hochspannungsversorgungsanlage. Andernfalls erzeugt sie an diesen Ausgängen ein Alarmsignal. Auch der gespeicherte simulierte Strom-Ist-Wert kann an den Ausgängen 21 gemeldet werden. Ein Alarmsignal kann auch dann erzeugt werden, wenn am Eingang 15' kein Abschaltsignal erscheint, obwohl das Testsignal bis zu einem einstellbaren, den Sollwert wesentlich übersteigenden Maximalwert hochgefahren wurde. Das beschriebene Hochfahren des Testsignals kann manuell oder selbsttätig erfolgen.

Zur praktischen Realisierung der Überprüfeinheit 20 genügt im wesentlichen ein entsprechend dem gewünschten Testsignal sowie von dem Abschaltsignal am Eingang 15' steuerbarer Spannungs-, Strom- oder Signalgenerator, dessen Ausgang einerseits z.B. dem Eingang 6 der Steuerschaltung 4 und andererseits dem einen Eingang eines Komparators (nicht dargestellt) zugeführt wird, der dieses Signal mit dem an seinen zweiten Eingang angelegten Strom-Soll-Wert vom Eingang 12' vergleicht. Das Ausgangssignal des Komparators kann als Alarmsignal dienen.

Es können fest installierte, jeweils einem Sprühgerät oder einer Gruppe von Sprühgeräten (Zerstäubern) zugeordnete Einheiten 20 zweckmäßig sein. Eine andere Möglichkeit besteht in der Verwendung eines die Überprüfeinheit 20 enthaltenden transportablen Gerätes, das jeweils bei Bedarf an den zu überprüfenden Anlagenteil angeschlossen wird.

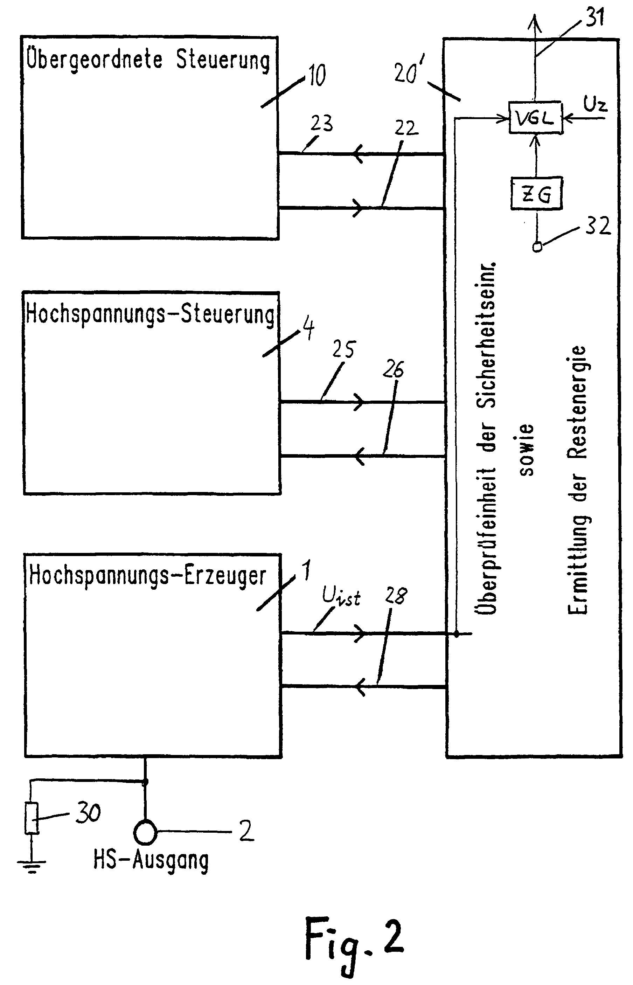

Bei der abgewandelten Ausführungsform nach Fig. 2 gibt die übergeordnete Steuerung 10 an Ausgängen 22 ein Befehlssignal zum Einschalten der Hochspannung sowie entsprechende Sollwerte für Strom und Spannung ab, während sie an ihren Eingängen 23 Informationen über Störungen wie z.B. Stromabschaltung bei Betrieb mit konstanter Spannung oder Unterspannungsabschaltung bei Betrieb mit konstantem Strom empfängt. Alle diese Signale bzw. Informationen werden in Eingänge 25 der Steuerschaltung 4 übertragen bzw. von deren Ausgängen 26 empfangen und hierbei darstellungsgemäß durch die Überprüfeinheit 20' geführt. Ferner empfängt die Steuerschaltung 4 vom Hochspannungserzeuger 1 ebenfalls über die Überprüfeinheit 20' die Ist-Werte der am Ausgang 2 an das Sprühorgan (nicht dargestellt) angelegten Spannung und des Stroms. Außerdem versorgt die Steuerschaltung 4 über die Einheit 20' den Hochspannungserzeuger 1 an dessen Eingang 28 mit dem erforderlichen Betriebsstrom. Die Steuerschaltung 4 und der Hochspannungserzeuger 1 bilden einen geschlossenen Regelkreis.

Auch bei dieser Ausführungsform können die Ist-Werte des Ausgangsstroms und der Spannung des Hochspannungserzeugers 1 in der oben beschriebenen Weise durch Testsignale simuliert werden, um künstlich Abschaltungen zu erzwingen, während der Hochspannungserzeuger 1 von seiner Steuerschaltung 4 und von der Versorgung am Eingang 28 getrennt, also abgeschaltet ist. Zusätzlich hierzu enthält die Überprüfeinheit 20' eine Schaltung zur Ermittlung der Restenergie, die nach dem manuellen oder durch eine Störung bewirkten Abschalten des Hochspannungserzeugers 1 in dem Energiespeichersystem verbleibt, das das an dem Ausgang 2 angeschlossene Sprühorgan bzw. dessen Hochspannungselektroden und alle hiermit elektrisch leitend verbundenen Bestandteile der Anlage ggf. einschließlich des Materialzuführsystems enthält, die im vorherigen Betrieb auf Hochspannung gelegt worden waren. Wie schon erwähnt wurde, muß das Energiespeichersystem nach dem Abschalten der Hochspannung so entladen werden, daß die gespeicherte Energie von ihrem sich im normalen Betrieb einstellenden Höchstwert innerhalb einer vorgeschriebenen Zeit von beispielsweise zwei Sekunden auf einen ungefährlichen Restenergiewert absinkt, der nach derzeitigen Bestimmungen höchstens 350 mWs betragen soll. Zu diesem Zweck ist üblicherweise zwischen das betrachtete Energiespeichersystem und Erde ein Entladewiderstand 30 geschaltet, der unter Berücksichtigung der relevanten Parameter der Anlage so dimensioniert worden ist, daß bei dem genannten Beispiel nach zwei Sekunden der ungefährliche Wert erreicht wird und die den Hochspannungserzeuger 1 und das Sprühorgan enthaltende Sprühkabine betreten werden darf. Ein anderes Sicherheitskriterium schreibt vor, daß bei Berühren eines der spannungsführenden Elemente kein Strom fließen darf, der einen ungefährlichen Wert von beispielsweise 0,7 mA übersteigt. Zwischen diesem Kriterium und der Begrenzung der dem System entnehmbaren Restenergie besteht natürlich ein enger Zusammenhang. Weniger sicherheitsrelevant ist dagegen bekanntlich eine Begrenzung der mit der gespeicherten Restenergie absinkenden Spannung des Energiespeichersystems. Diese Spannung wird aber in oder an dem Hochspannungserzeuger 1 und/oder in der Überprüfeinheit 20' ständig und kontinuierlich gemessen.

Da die erforderliche Sicherheit bei den bisher üblichen Anlagen nicht mehr gewährleistet ist, wenn das Energiespeichersystem nicht richtig über den Entladewiderstand 30 oder durch sonstige Maßnahmen der bekannten Anlage entladen wird, soll die Überprüf-einheit 20' am Ausgang 31 ein als Warnung oder beispielsweise zum Sperren des Zugangs zu der Sprühkabine verwendbares Signal erzeugen, wenn die Restenergie nach der gewählten Sicherheitszeitspanne nach dem Abschalten der Hochspannung noch höher ist als der genannte Wert von 350 mWs. Zu diesem Zweck wird zunächst beispielsweise schon bei der Installation der Anlage die Gesamtkapazität C des Energiespeichersystems 4 gemessen und gespeichert. Hieraus wird dann nach der Formel $U_z = \sqrt{2E/C}$ mit E=350 mWs der für die betrachtete Anlage zulässige Spannungswert $U_z$ errechnet, der nach der gewählten Zeit erreicht sein muß. $U_z$ wird gespeichert. Die Überprüfeinheit 20' enthält einen Zeitgeber ZG, der an einem Eingang 32 von einem gleichzeitig mit dem Abschalten des Hochspannungserzeugers 1 erzeugten Signal eingeschaltet wird und an seinem Ausgang den Ablauf der gewählten Zeitspanne (z.B. 2 Sekunden) einer Vergleichsschaltung VGL meldet. Die Vergleichsschaltung VGL vergleicht zu diesem Zeitpunkt die der tatsächlichen Spannung des Energiespeichersystems entsprechende kontinuierlich gemessene Ausgangsspannung $U_{ist}$ des Hochspannungserzeugers 1 mit dem zulässigen Spannungswert $U_z$. Wenn $U_{ist}$ den Wert $U_z$ übersteigt, wird am Ausgangs 31 das erwähnte Alarm- und/oder Schaltsignal erzeugt.

Der Zeitpunkt des Vergleiches wird aufgrund der jeweiligen Erfordernisse der Praxis gewählt. Wenn sich anlagenbedingte Änderungen des betrachteten Energiespeichersystems ergeben, ist es lediglich erforderlich, die Gesamtkapazität dieses Systems erneut zu messen und die Restenergieermittlungsschaltung der Überprüfeinheit 20' entsprechend neu zu kalibrieren.

## Patentansprüche

1. Verfahren zur Sicherheitsüberprüfung einer einen Hochspannungserzeuger (1) und deren Steuerschaltung (4) enthaltenden Hochspannungsversorgungsanlage für elektrostatische Sprühanlagen, bei der bei Überschreiten oder Unterschreiten eines vorbestimmten Strom- oder Spannungswertes eine Sicherheitsmaßnahme erforderlich ist, insbesondere die Hochspannung abgeschaltet werden muß, wobei der Steuerschaltung (4) des Hochspannungserzeugers (1) den von diesem erzeugten Spannungs- oder Stromwerten entsprechende Testspannungen oder Testströme zugeführt werden und festgestellt wird, ob die Steuerung bei Erreichen des vorbestimmten Wertes die Sicherheitsmaßnahme einleitet,
dadurch gekennzeichnet, daß die Testspannungen oder Testströme der Steuerschaltung (4) zur Überprüfung als unabhängig von dem Hochspannungserzeuger (1) erzeugte Testsignale (6', 7') zugeführt werden.

2. Verfahren nach Anspruch 1,
dadurch gekennzeichnet, daß der Hochspannungssteuerschaltung (4) bei der Überprüfung ein von einer übergeordneten Steuerung (10) der Sprühanlage erzeugter Sollwert für Spannung und/oder Strom des Hochspannungserzeugers als Ist-Wert unabhängig von dem Hochspannungserzeuger zugeführt wird.

3. Verfahren nach Anspruch 1 oder 2,
dadurch gekennzeichnet, daß der Steuerschaltung (4) zur Überprüfung der Hochspannungsversorgungsanlage Testsignale (6', 7') zugeführt werden, die von einem Null oder einem niedrigen Strom entsprechenden Wert bis zu einem solchen Stromwert variiert werden, bei dem die Steuerschaltung (4) ein Hochspannungsabschaltsignal erzeugt.

4. Verfahren nach Anspruch 3,
dadurch gekennzeichnet, daß der Testsignalwert, bei dem das Abschaltsignal erzeugt wird, selbsttätig gespeichert wird.

5. Verfahren nach Anspruch 3 oder 4,
dadurch gekennzeichnet, daß der Testsignalwert, bei dem das Abschaltsignal erzeugt wird, mit dem von der übergeordneten Steuerung (10) der Sprühanlage erzeugten Sollwert verglichen wird, und daß ein Alarmsignal erzeugt wird, wenn die Abweichung dieser Werte eine vorgegebene Grenze überschreitet.

6. Verfahren nach Anspruch 5,
   **dadurch gekennzeichnet, daß** der zulässige Abweichungsbereich einstellbar ist.

7. Verfahren nach Anspruch 1 zur Sicherheitsüberprüfung einer elektrostatischen Sprühanlage, bei der im Betrieb elektrische Energie in dem System gespeichert wird, das die auf Hochspannung gelegten Elemente der Sprüheinrichtung und die hiermit im Betrieb und in Betriebspausen elektrisch leitend verbundenen Bestandteile der Anlage enthält, und bei der in Betriebspausen nach Abschalten der Hochspannung dieses Energiespeichersystem bis auf einen ungefährlichen Restenergiewert entladen wird, bevor der Zugang in den die Sprüheinrichtung enthaltenden Raum zulässig wird,
   **dadurch gekennzeichnet,**
   **daß** vor Betriebsbeginn die elektrische Kapazität des Energiespeichersystems gemessen und gespeichert wird,
   **daß** aus dem gespeicherten Kapazitätswert der dem ungefährlichen Restenergiewert entsprechende zulässige Spannungswert errechnet wird,
   **daß** in Betriebspausen nach dem Abschalten der Hochspannung festgestellt wird, ob zu einem vorbestimmten Zeitpunkt nach dem Abschalten die an dem Energiespeichersystem gemessene Spannung auf den zulässigen oder einen niedrigeren Wert abgesunken ist,
   und **daß** ein Alarmsignal und/oder ein den Zugang zu dem die Sprüheinrichtung enthaltenden Raum verhinderndes Signal erzeugt wird, wenn die Spannung zu diesem Zeitpunkt unzulässig hoch ist.

8. Verfahren nach Anspruch 7, **dadurch gekennzeichnet,**
   **daß** der Ist-Wert der an die Sprüheinrichtung angelegten Hochspannung kontinuierlich gemessen und nach Ablauf der vorbestimmten Zeit jeweils nach Abschalten der Hochspannung automatisch mit dem zulässigen Spannungswert verglichen wird.

9. Schaltungsanordnung zur Sicherheitsüberprüfung einer einen Hochspannungserzeuger (1) und des-sen Steuerschaltung (4) enthaltenden Hochspan-nungsversorgungsanlage für elektrostatische Sprühanlagen, bei der bei Überschreiten oder Unterschreiten eines vorbestimmten Strom- oder Spannungswertes eine Sicherheitsmaßnahme erforderlich ist, insbesondere die Hochspannung abgeschaltet werden muß, mit einer Überprüfeinheit (20), die der Steuerschaltung (4) des Hochspannungserzeugers (1) den von diesem erzeugten Spannungs- oder Stromwerten entsprechende Spannungen oder Ströme zuführt und feststellt, ob die Steuerung bei Erreichen des vorbestimmten Wertes die Sicherheitsmaßnahme einleitet, wobei die Steuerschaltung (4) Ist-Wert-Eingänge (6, 7) für Strom und/oder Spannung hat, die im Sprühbetrieb mit dem Hochspannungserzeuger (1) verbunden sind,
   **dadurch gekennzeichnet, daß** die Überprüfeinheit (20) als Testspannung oder Teststrom Signale erzeugt, die an den Ist-Wert-Eingang (6) der Steuerschaltung (4) anlegbar sind, während die Verbindung zwischen dem Ist-Wert-Eingang (6) und dem Hochspannungserzeuger (1) unterbrochen ist.

10. Schaltungsanordnung nach Anspruch 9,
    **dadurch gekennzeichnet, daß** die Größe der Testsignale manuell oder selbsttätig zwischen Null oder einem niedrigen Wert und einem solchen Wert variierbar ist, bei dem die Hochspannungssteuerschaltung (4) ein Abschaltsignal (15) erzeugt.

11. Schaltungsanordnung nach Anspruch 9 zur Sicher-heitsüberprüfung einer Hochspannungsversor-gungsanlage, bei der bei Überschreiten oder Unterschreiten eines vorbestimmten Strom- oder Span-nungswertes eine Sicherheitsmaßnahme erforder-lich ist, insbesondere die Hochspannung abgeschaltet werden muß, mit einer Überprüfeinheit (20), die der Steuerschaltung (4) des Hochspannungserzeugers (1) den von diesem erzeugten Spannungs- oder Stromwerten entsprechende Spannungen oder Ströme zuführt und feststellt, ob die Steuerung bei Erreichen des vorbestimmten Wertes die Sicherheitsmaßnahme einleitet, wobei die Steuerschaltung (4) Ist-Wert-Eingänge (6, 7) für Strom und/oder Spannung hat, die im Sprühbetrieb mit dem Hochspannungserzeuger (1) verbunden sind,
    **dadurch gekennzeichnet,**
    **daß** daß die Überprüfeinheit (20) als Testspannung oder Teststrom Signale erzeugt, die an den Ist-Wert-Eingang (6) der Steuerschaltung (4) anlegbar sind, während die Verbindung zwischen dem Ist-Wert-Eingang (6) und dem Hochspannungserzeuger (1) unterbrochen ist.

## Claims

1. Method for safety check of a high-voltage supply system for electrostatic spray equipment containing a high voltage generator (1) and its control circuit (4), requiring a safety measure to be initiated if the voltage or current exceeds or falls below a predetermined value, in particular requiring the high-voltage to be switched off, wherein the control circuit (4) of the high-voltage generator (1) receives test voltages or test currents corresponding to the voltage or current values generated by the generator, and it is established whether the control initiates the safety measure when the predetermined value is reached, **characterised in that** the test voltages or test currents are supplied to the control circuit (4) as test signals (6', 7') generated independently of the high-voltage generator (1).

2. Method according to claim 1, **characterised in that**, in the safety check, the high voltage control circuit (4) receives a set value for voltage and/or current of the high-voltage generator from a higher-ranking control unit (10) of the spray equipment as actual value independent of the high-voltage generator.

3. Method according to claim 1 or 2, **characterised in that** the control circuit (4) for checking the high-voltage supply system receives test signals (6', 7'), which are varied from a zero or a low current value to such a current value, at which the control circuit (4) creates a high-voltage off signal.

4. Method according to claim 3, **characterised in that** the test signal, at which the off signal is created, is stored automatically.

5. Method according to claims 3 or 4, **characterised in that** the test signal value at which the off signal is generated, is compared with the set value generated by the higher-ranking control unit (10) of the spray equipment and that an alarm signal is generated, when these values differ by more than a set range.

6. Method according to claim 5, **characterised in that** the permissible range of deviation can be freely selected.

7. Method according to claim 1 for the safety check of electrostatic spray equipment, during the operation of which electrical energy is stored within the system, containing the high-voltage elements of the spray equipment and those components which are electrically connected therewith during operation and operational breaks, and in which this energy storing system is discharged to a safe residual energy value during operational breaks and after the high-voltage has been switched off, prior to the area containing the spray equipment becoming accessible, **characterised in that**, before work commences, the electric capacity of the energy storing system is measured and stored, and that the permissible voltage value corresponding to the safe residual energy value is calculated from the stored capacity value, and that in operational breaks, after the high-voltage has been switched off, it is established whether, at a set time after switching off, the actual voltage measured at the energy storing system has been reduced to a permissible or lower value, and that an alarm signal and/or a signal preventing access to the spray equipment area is generated if, at that time, the voltage is unacceptably high.

8. Method according to claim 7, **characterised in that** the actual value of the high-voltage supplied to the spray equipment is continually measured and, after expiry of the set time after the high-voltage has been switched off, is compared automatically to the permissible voltage value.

9. Circuit arrangement for the safety check of a high-voltage supply system for electrostatic spray equipment containing a high-voltage generator (1) and its circuit control (4), requiring a safety measure to be initiated if the current or voltage exceeds or falls below a predetermined value, in particular requiring the high-voltage to be switched off, comprising a monitoring unit (20) supplying the control circuit (4) of the high-voltage generator (1) with voltages and currents corresponding to the voltage and current values generated by said generator, and which checks whether the control initiates the safety measure upon reaching the predetermined value, wherein the control unit (4) comprises inputs for actual values (6, 7) for current and/or voltage which, during the spraying operation, are connected to the high-voltage generator (1) **characterised in that** the monitoring unit (20) generates signals as test voltage or test current, which can be supplied to the input for actual values (6) of control unit (4), whilst the connection between the input for actual values (6) and the high-voltage generator (1) is interrupted.

10. Circuit arrangement according to claim 9, **characterised in that** the magnitude of the test signals can be manually or automatically varied between zero or a low value and such a value, at which the high-voltage control unit (4) generates an off signal (15).

11. Circuit arrangement according to claim 9 for the check of a high-voltage supply system, requiring a safety measure if the current or voltage exceeds or falls below a predetermined value, in particular requiring the high-voltage to be switched off, comprising a monitoring unit (20), which supplies the control unit (4) of the high-voltage generator (1) with voltages or currents corresponding to the voltage or current values generated by said generator and which establishes, whether the control initiates the safety measure upon reaching the predetermined value, and wherein the control unit (4) provides inputs for actual values (6, 7) for voltage and/or current, which, during the spraying operation, are connected with the high-voltage generator (1), **characterised in that** the monitoring unit (20) generates signals as test voltage or test current, which can be supplied to the input for actual values (6) of the control unit (4), whilst the connection between the input for actual values (6) and the high-voltage generator (1) is interrupted.

## Revendications

1. Procédé de surveillance de la sécurité d'une installation d'alimentation à haute tension pour des installations de pulvérisation électrostatique, comprenant un générateur de haute tension (1) et son circuit de commande (4), dans laquelle, en cas de dépassement vers le haut ou vers le bas d'une valeur déterminée de courant ou de tension, une action de sécurité est nécessaire, en particulier la haute tension doit être coupée, selon lequel on applique au circuit de commande (4) du générateur de haute tension (1), des tensions de test ou des courants de test, qui correspondent aux valeurs de tension ou de courant produites par ledit générateur de haute tension, et on examine si la commande, lorsque la valeur prédéterminée est atteinte, déclenche l'action de sécurité, **caractérisé en ce qu'**on applique les tensions de test ou les courants de test du circuit de commande (4), à des fins de surveillance, sous forme de signaux de test (6', 7') produits indépendamment du générateur de haute tension (1).

2. Procédé selon la revendication 1, **caractérisé en ce qu'**on applique au circuit de commande (4) de haute tension, lors du contrôle, comme valeur réelle indépendante du générateur de tension, une valeur de consigne pour la tension et/ou le courant du générateur de haute tension produite par une commande (10) prioritaire de l'installation de pulvérisation.

3. Procédé selon la revendication 1 ou 2, **caractérisé en ce qu'**on applique au circuit de commande (4), pour le contrôle de l'installation d'alimentation à haute tension, des signaux de test (6', 7)') que l'on fait varier depuis zéro ou une valeur correspondant à un courant faible jusqu'à une valeur de courant, pour laquelle le circuit de commande (4) produit un signal de coupure de la haute tension.

4. Procédé selon la revendication 3, **caractérisé en ce qu'**on mémorise de manière automatique la valeur du signal de test pour laquelle le signal de coupure est produit.

5. Procédé selon la revendication 3 ou 4, **caractérisé en ce qu'**on compare la valeur du signal de test, pour laquelle le signal de coupure est produit, à la valeur de consigne produite par la commande (10) prioritaire de l'installation de pulvérisation et **en ce qu'**on produit un signal d'alarme lorsque l'écart entre ces valeurs dépasse un seuil prédéterminé.

6. Procédé selon la revendication 5, **caractérisé en ce que** la plage d'écart admissible est réglable.

7. Procédé selon la revendication 1 pour la surveillance de la sécurité d'une installation de pulvérisation électrostatique, dans laquelle, pendant le fonctionnement, de l'énergie électrique est accumulée dans le système, qui comprend les éléments sous haute tension du dispositif de pulvérisation ainsi que les parties de l'installations reliées de manière électriquement conductrice à ceux-ci en fonctionnement et pendant les pauses, et dans laquelle, pendant les pauses, après coupure de la haute tension, ledit système accumulateur d'énergie est déchargé jusqu'à une valeur d'énergie résiduelle non dangereuse avant que l'accès à l'enceinte contenant le dispositif de pulvérisation soit autorisé, **caractérisé en ce qu'**avant le début du fonctionnement, on mesure la capacité électrique du système accumulateur d'énergie et on la mémorise, **en ce qu'**à partir de la valeur de capacité mémorisée on calcule la valeur de tension admissible correspondant à la valeur d'énergie résiduelle non dangereuse, **en ce que** pendant les pauses de fonctionnement après la coupure de la haute tension, on examine si, à un instant prédéterminé après la coupure, la tension mesurée dans le système accumulateur d'énergie a chuté à la valeur admissible ou à une valeur inférieure, et **en ce qu'**un signal d'alarme et/ou un signal interdisant l'accès à l'enceinte contenant le dispositif de pulvérisation est produit lorsque la tension, à cet instant, est supérieure à la valeur admissible.

8. Procédé selon la revendication 7, **caractérisé en ce qu'**on mesure en continu la valeur réelle de la haute tension appliquée au dispositif de pulvérisation et après écoulement d'un laps de temps prédéterminé après la coupure de la haute tension, on la compare automatiquement à la valeur de tension admissible.

9. Dispositif pour la surveillance de la sécurité d'une installation d'alimentation à haute tension pour des installations de pulvérisation électrostatique, comprenant un générateur de haute tension (1) et son circuit de commande (4), dans laquelle, en cas de dépassement vers le haut ou vers le bas d'une valeur déterminée de courant ou de tension, une action de sécurité est nécessaire, en particulier la haute tension doit être coupée, comportant une unité de surveillance (20), qui applique au circuit de commande (4) du générateur de haute tension (1) des tensions ou des courants qui correspondent aux valeurs de tension ou de courant produites par ledit générateur de haute tension et examine si la commande déclenche l'action de sécurité lorsque la valeur prédéterminée est atteinte, le circuit de commande (4) comportant des entrées (6, 7) de valeur réelle pour le courant et/ou la tension qui, en fonctionnement de pulvérisation, sont reliées au générateur de haute tension (1), **caractérisé en ce que** l'unité de surveillance (20) produit comme tension de test ou comme courant de test des signaux qui peuvent être appliqués à l'entrée de valeur réelle (6) du circuit de commande (4), pendant que la liaison entre l'entrée de valeur réelle (6) et le générateur de haute tension (1) est interrompue.

**10.** Circuit selon la revendication 9, **caractérisé en ce qu'**on peut faire varier la valeur des signaux de test manuellement ou de manière automatique entre zéro ou une faible valeur et une valeur pour laquelle le circuit de commande (4) de haute tension produit un signal de coupure (15).

**11.** Circuit selon la revendication 9, pour la surveillance de la sécurité d'une installation d'alimentation à haute tension pour des installations de pulvérisation électrostatique, dans laquelle, en cas de dépassement vers le haut ou vers le bas d'une valeur déterminée de courant ou de tension, une action de sécurité est nécessaire, en particulier la haute tension doit être coupée, comprenant une unité de surveillance (20) qui applique au circuit de commande (4) du générateur de haute tension (1) des tensions qui correspondent aux valeurs de tension ou de courant produites par celui-ci et examine si la commande déclenche l'action de sécurité lorsque la valeur prédéterminée est atteinte, le circuit de commande (4) comportant des entrées (6, 7) de valeur réelle pour le courant et/ou la tension qui, en fonctionnement de pulvérisation, sont reliées au générateur de haute tension (1), **caractérisé en ce que** l'unité de surveillance (20) produit comme tension de test ou comme courant de test des signaux qui peuvent être appliqués à l'entrée de valeur réelle (6) du circuit de commande (4) pendant que la liaison entre l'entrée de valeur réelle (6) et le générateur de haute tension (1) est interrompue.

Fig.1

Fig. 2

Übergeordnete Steuerung — 10

Hochspannungs-Steuerung — 4

Hochspannungs-Erzeuger — 1

$U_{ist}$ — 28

23

22

25

26

20'

31

VGL — $U_z$

ZG

32

Überprüfeinheit der Sicherheitseinr. sowie Ermittlung der Restenergie

30

HS-Ausgang — 2